# FASCICULE DE BREVET EUROPEEN

(11) **EP 3 585 723 B1**
(45) Date de publication et mention de la délivrance du brevet: **01.06.2022**
(21) Numéro de dépôt: 18731506.4
(22) Date de dépôt: 20.04.2018
(51) Int. Cl.: B81B 3/00

(54) **DISPOSITIF MEMS OU NEMS À EMPILEMENT DE BUTÉE**
MEMS- ODER NEMS-VORRICHTUNG MIT GESTAPELTEM STOPPELEMENT
MEMS OR NEMS DEVICE WITH STACKED STOP ELEMENT

(30) Priorité: 23.02.2017 FR 1751433
(43) Date de publication de la demande: 01.01.2020
(73) Titulaire: SAFRAN, 75015 Paris (FR); Commissariat à l'Énergie Atomique et aux Énergies Alternatives, 75015 Paris (FR)
(72) Inventeur: LEHEE, Guillaume Jérôme François, 77550 Moissy-Cramayel (FR); ONFROY, Philippe Serge Claude, 77550 Moissy-Cramayel (FR); COLIN, Mikael, 38000 Grenoble (FR)
(74) Mandataire: Regimbeau
(86) Numéro de dépôt international: PCT/FR2018/000095
(87) Numéro de publication internationale: WO 2018/154196

(56) Documents cités:
- US-A1- 2010 258 885
- US-A1- 2013 019 678

## Description

La présente invention s'inscrit dans le domaine technique des dispositifs électromécaniques, notamment MEMS (pour Micro Electro-Mechanical Systems) ou NEMS (pour Nano Electro-Mechanical Systems), en particulier ceux comprenant des éléments mobiles de dimensions millimétriques, micrométriques, voire nanométriques polarisés électriquement, comme des capteurs ou actionneurs électrostatiques.

Il est courant d'exploiter des forces d'attraction ou de répulsion, notamment des interactions électrostatiques, pour réaliser une fonction électrique, par exemple actionnement ou détection, au sein de dispositifs MEMS. Des formes simples d'actionneurs électrostatiques, comprenant deux électrodes comprenant au moins une zone plane et se faisant face, auxquelles on applique une tension différente, sont connues en soi. Il est également connu d'utiliser des peignes interdigités comme électrodes dans un tel actionneur, par exemple pour couvrir une amplitude de déplacement plus importante.

L'un des principaux modes de défaillance des dispositifs électromécaniques MEMS ou NEMS est le collage d'éléments mobiles, notamment par les forces de Van der Waals ou par interaction électrostatique d'éléments mobiles polarisés différemment. Un mode de défaillance à éviter est le micro-arcage : un arc électrique peut apparaître lorsque des éléments mobiles polarisés différemment sont polarisés par des niveaux de potentiels élevés (typiquement plusieurs dizaines de volts), et/ou lorsque les éléments mobiles sont peu distants l'un de l'autre (typiquement de l'ordre du micromètre, ou inférieur). D'autre part, ces éléments mobiles et les éléments avoisinants sont susceptibles d'être détériorés par des chocs violents et/ou répétés.

Pour pallier ces problèmes, une solution connue, pour deux tels éléments mobiles plans agencés sur le même plan, consiste à implémenter des éléments de butée rigides ou flexibles mécaniquement robustes sur la zone où lesdits éléments mobiles sont susceptibles de rentrer en contact. Les forces d'adhésion, qui dépendent de la surface de contact, sont par conséquent limitées.

Cependant, la mise en contact d'une butée présentant une certaine polarité avec un élément de polarité différente peut générer un courant traversant et une décharge électrostatique, ce qui peut compromettre la fonctionnalité de l'actionneur voire l'endommager de manière irréversible. Le risque de micro-arcage n'est pas complètement évité. Il a alors été proposé d'isoler électriquement une telle butée de l'élément mobile hors duquel elle fait saillie, de telle sorte que son contact avec l'élément en regard (la contrebutée) ne présente pas un risque de collage électrostatique ou de décharge électrostatique.

La demande de brevet US 2015/0033849 A1 décrit un dispositif pouvant être implémenté au sein d'un capteur inertiel MEMS, comprenant une masse plane mobile et une plaque de détection parallèle en regard. La masse mobile et la plaque de détection sont placées à des potentiels électriques différents. Pour éviter une décharge électrostatique lors d'événements d'accélération ou de choc mettant en mouvement la masse mobile, la plaque de détection porte des éléments de butée orientés selon une direction sensiblement perpendiculaire au plan de la plaque de détection. Lesdits éléments de butée sont isolés électriquement de la plaque de détection et placés au même potentiel que celui de la masse mobile en regard. Toutefois, cette solution n'est pertinente que si le mouvement relatif des éléments mobiles se fait hors plan, avec une composante selon la direction perpendiculaire aux éléments mobiles plans (verticale dans cet exemple) pouvant produire un contact entre deux éléments mobiles avec risque de décharge électrostatique.

Les documents US 2010/258885 A1 et US 2013/019678 A1 décrivent également des dispositifs MEMS pourvus de butées.

### PRESENTATION GENERALE DE L'INVENTION

La présente invention propose une solution appropriée pour deux électrodes planes coplanaires situés sur une même couche au sein d'un dispositif MEMS ou NEMS, mobiles l'une par rapport à l'autre selon au moins une première direction de déplacement comprise dans le plan des électrodes, les électrodes étant destinées à être placées à des potentiels différents.

La solution de l'invention assure la tenue mécanique en fonctionnement de ces deux éléments mobiles l'un par rapport à l'autre, tout en préservant leur fonctionnalité électromécanique, après un événement vibratoire ou de choc entraînant leur mouvement dans le plan.

En sus d'une première couche plane comprenant deux éléments dont au moins un mobile, polarisés différemment (typiquement des électrodes) et assurant à eux deux la fonctionnalité électromécanique requise, il est proposé d'implémenter une couche supplémentaire isolée électriquement de la première, comprenant des éléments mobiles l'un par rapport à l'autre, mécaniquement solidaires des deux éléments de la première couche, pouvant être mis en mouvement dans leur plan et buter l'un contre l'autre.

L'invention vise à éviter un contact direct entre deux éléments polarisés différemment dont on souhaite préserver la fonction, voire à éviter que lesdits éléments ne soient suffisamment proches pour engendrer un phénomène de micro-arcage. De ce fait, la tenue mécanique et électrique desdits éléments est assurée même en cas d'événement vibratoire ou de choc, et même si lesdits éléments sont constitués de matériaux fragiles.

Les risques liés aux interactions électrostatiques sont ainsi limités avec une mise en œuvre simple et fiable, adaptée à un dispositif de dimensions micrométriques ou nanométriques, dans ùn souci de miniaturisation d'un tel dispositif.

Ainsi, l'invention concerne un dispositif MEMS ou NEMS tel que défini dans les revendications. La butée peut venir en contact avec ladite surface de l'élément plan en regard, et bloquer le rapprochement des deux électrodes planes de la première couche plane selon la première direction lors d'une sollicitation, afin d'éviter qu'elles ne soient trop proches.

De manière avantageuse mais non limitative, dans un état non sollicité comme en sortie d'usine, l'empilement est agencé pour que, si l'on considère la distance d'excursion libre de la butée, entre l'élément de butée et l'élément plan en regard, selon la première direction susmentionnée de déplacement des électrodes, ladite distance d'excursion libre soit inférieure à la distance minimale entre toute extrémité libre de la première électrode plane et une extrémité la plus proche de la deuxième électrode plane, prise selon cette même première direction. L'élément de butée peut alors, lors d'un événement induisant un déplacement relatif des deux électrodes selon cette même première direction, interrompre ledit mouvement relatif des deux électrodes avant que la première électrode ne soit mise en contact avec la deuxième.

De façon optionnelle, au moins l'une des électrodes planes de la première couche est prise au moins partiellement déformable selon la première direction. Une distance de flèche d'électrode est alors définie comme la déformation maximale de l'électrode déformable selon cette même direction, ou la somme des déformations maximales des deux électrodes, si les deux électrodes sont prises déformables selon la première direction. La distance minimale entre les électrodes est alors prise supérieure à la somme de la distance de flèche d'électrode et de la première distance d'excursion libre des électrodes.

De façon optionnelle, et cumulative ou non avec la déformabilité des électrodes, au moins l'une des éléments plans de la deuxième couche est pris au moins partiellement déformable selon la première direction. Une distance de flèche d'élément plan est alors définie comme la déformation maximale dudit élément plan (par exemple de la butée, si ledit élément plan porte une butée) selon cette même direction, ou la somme des déformations maximales des deux éléments plans, si les deux éléments plans sont pris déformables selon la première direction. La distance minimale entre les électrodes est alors prise supérieure à la somme de la distance de flèche d'élément plan et de la première distance d'excursion libre des électrodes.

Selon une implémentation particulière, où l'un des deux éléments plans est partiellement déformable selon la première direction, la deuxième couche plane est percée d'une cavité (non débouchante, qui ne traverse pas l'empilement complet), pratiquée à l'ancrage de la butée. Selon une autre implémentation, qui peut ou non être cumulée à la première, la deuxième couche plane est percée d'une cavité non débouchante, le long du bord externe de la contrebutée (surface en regard de la butée). Dans les deux implémentations, la distance de flèche d'éléments plans est la somme des dimensions des deux cavités, ou la dimension de l'unique cavité si une seule cavité est pratiquée.

Selon une autre implémentation, où le premier élément plan porte un premier élément de butée (par exemple sous forme de poutre) et le deuxième élément plan porte un deuxième élément de butée similaire, les deux électrodes planes et les deux éléments plans sont déformables selon la première direction.La déformabilité est obtenue par deux cavités débouchantes, qui traversent l'empilement,
une première étant pratiquée à l'ancrage de la première butée, en correspondance selon la première direction avec la première butée mais pas avec la deuxième butée, formant une première lame flexible,
une deuxième étant pratiquée à l'ancrage de la deuxième butée, en correspondance selon la première direction avec la deuxième butée mais pas avec la première butée, formant une deuxième lame flexible.

La première distance d'excursion libre est alors définie comme la distance minimale entre l'une des butées et la contrebutée. La distance de flèche d'électrodes est alors la somme des dimensions des deux cavités débouchantes. Dans une variante de cette dernière implémentation, où l'on conserve les mêmes premier et deuxième éléments de butée,
une première cavité débouchante est pratiquée dans la première électrode plane, en correspondance selon la première direction avec une extrémité de la deuxième butée, formant une première lame flexible,
et une deuxième cavité débouchante est pratiquée toujours dans la première électrode plane, à l'ancrage du premier élément de butée, en correspondance selon la première direction avec la première butée. Les deux cavités débouchantes sont donc pratiquées côte-à-côte pour former deux lames flexibles juxtaposées.

La première distance d'excursion libre est alors définie comme la distance minimale entre l'une des butées et la surface en regard dans la deuxième couche.

De façon optionnelle, par exemple en relation avec les deux dernières implémentations sus-citées, les deux électrodes sont également mobiles l'une par rapport à l'autre selon une deuxième direction sensiblement perpendiculaire à la première direction, la deuxième direction étant parallèle aux couches de l'empilement. Le premier élément plan comprend une première butée et le deuxième élément plan comprend une deuxième butée. L'empilement est alors configuré de sorte que dans l'état non sollicité, toute extrémité libre de la première électrode plane se trouve, par rapport à la deuxième électrode plane, à une distance minimale supérieure à une deuxième distance d'excursion libre qui correspond à la deuxième direction, la deuxième distance d'excursion libre étant prise comme la distance minimale entre les deux butées selon la deuxième direction.

De façon avantageuse mais non limitative, une électrode comprend une plaque plane.

De façon avantageuse mais non limitative, une électrode comprend un peigne électrostatique.

### PRESENTATION DES FIGURES

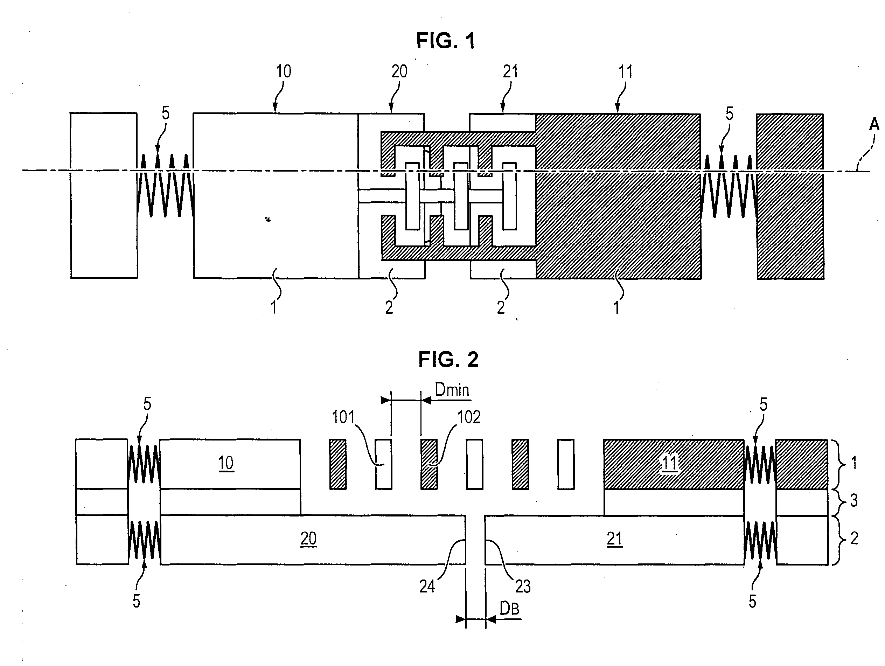

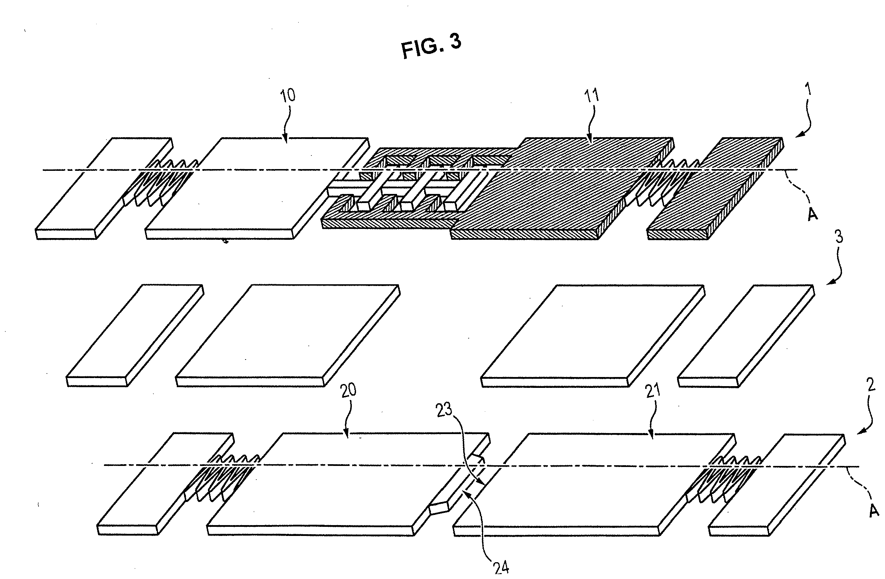

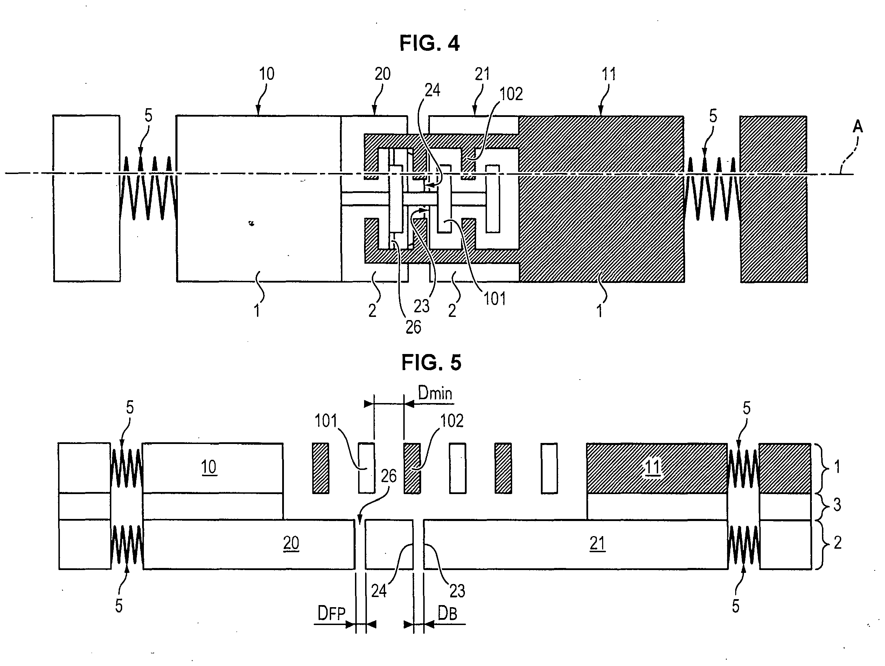

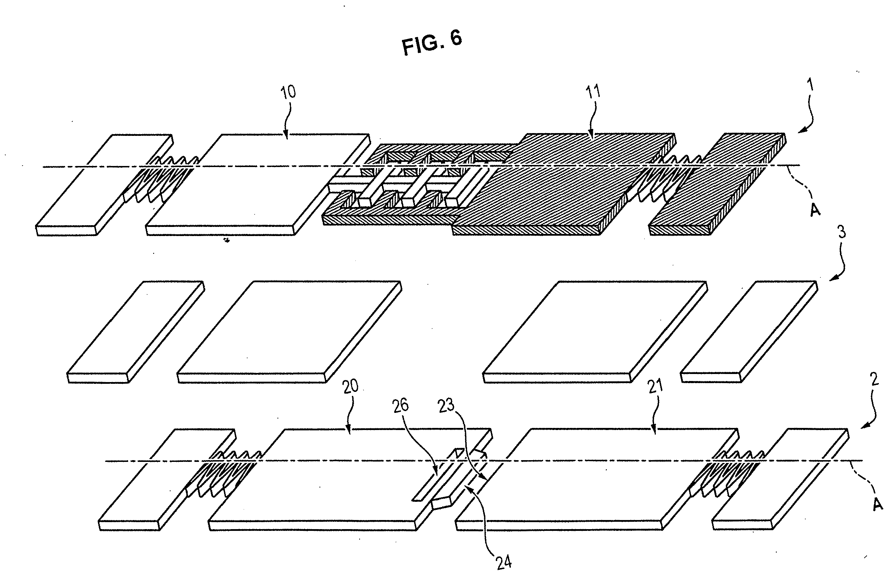

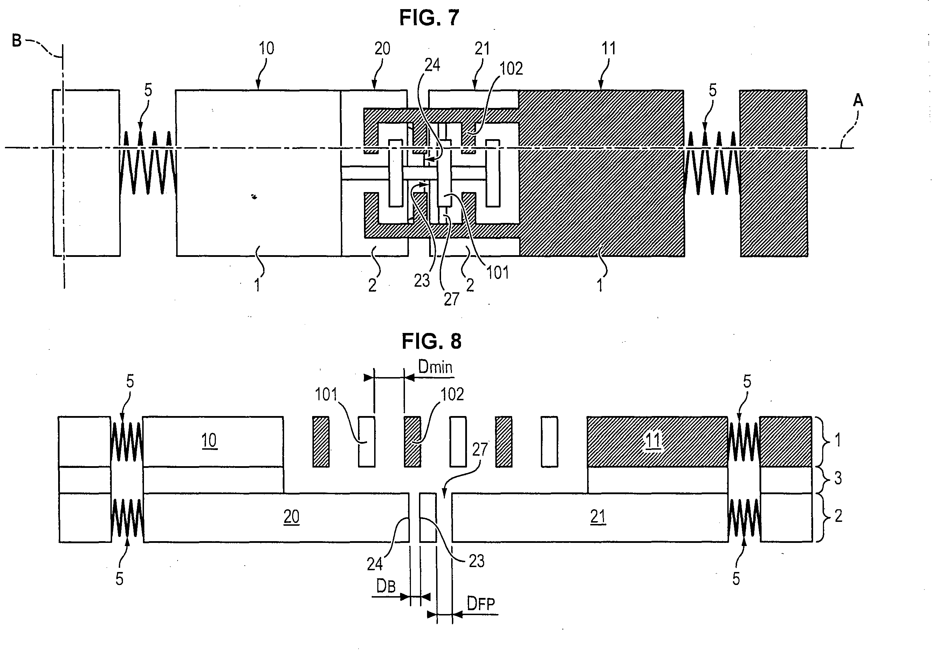

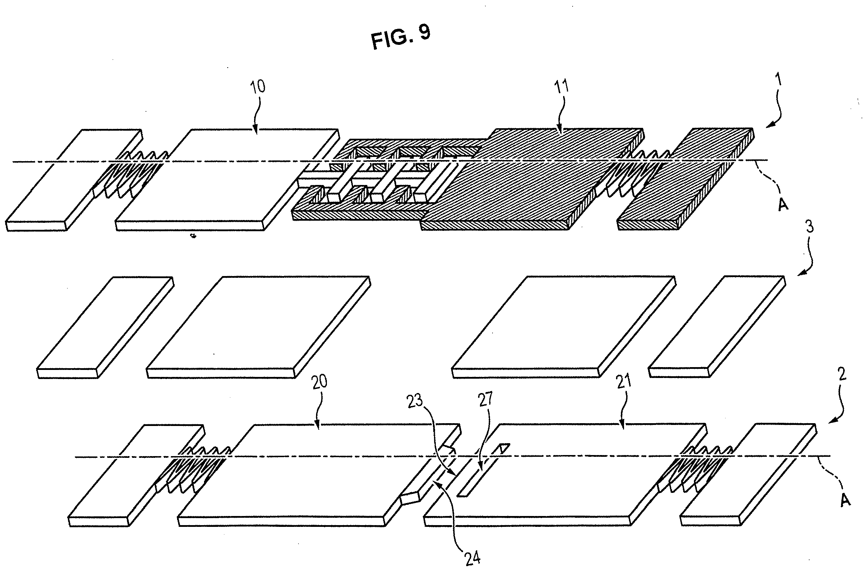

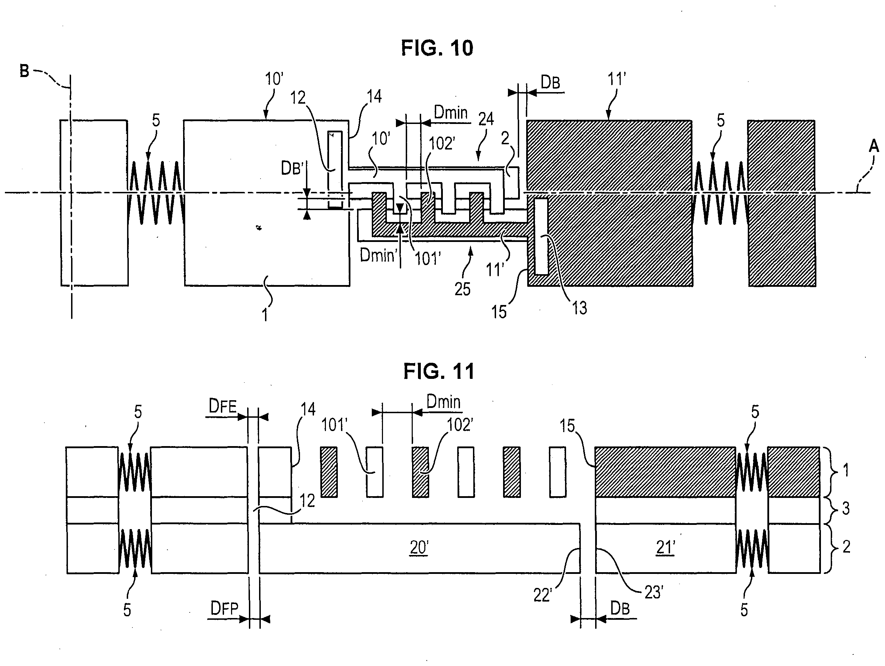

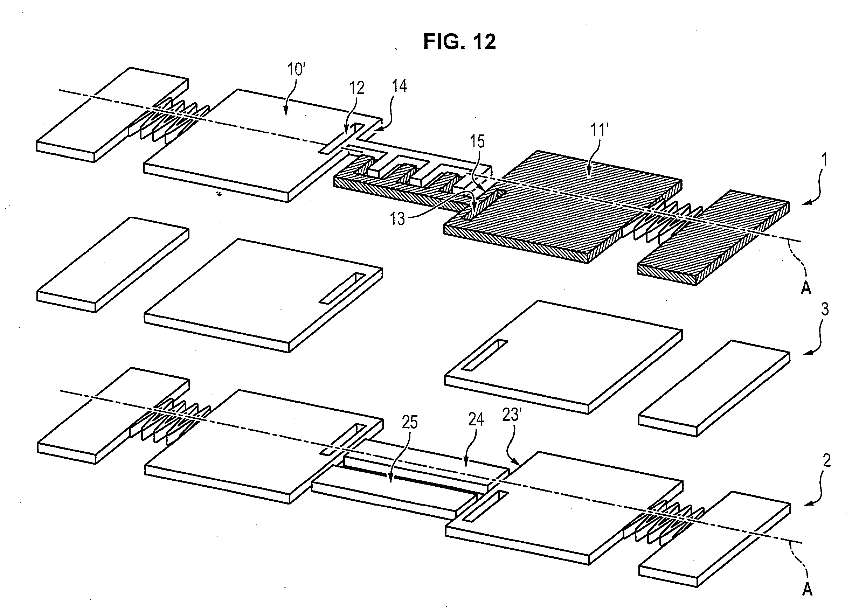

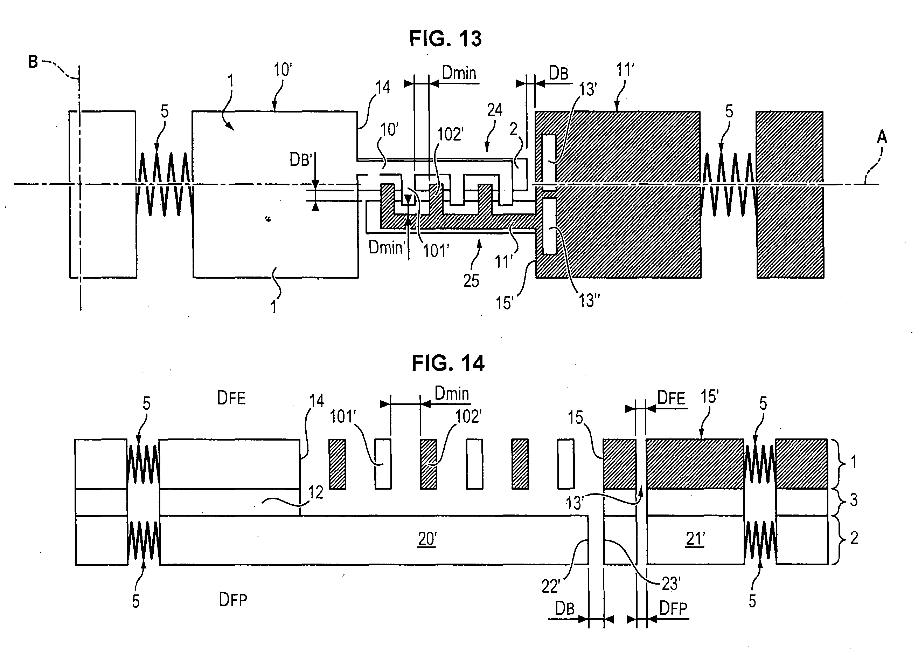

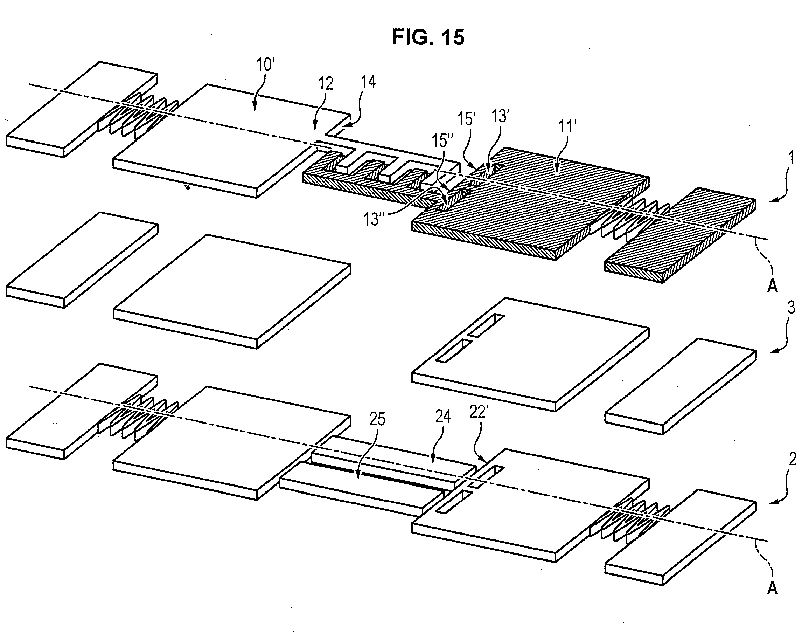

D'autres caractéristiques, buts et avantages de la présente invention apparaîtront mieux dans les modes de réalisation particuliers décrits ci-après, ainsi qu'à la vue des figures suivantes, qui doivent être interprétées à titre purement illustratif et non limitatif.
**La** **figure 1** est une vue schématique d'un empilement de butée suivant un premier mode de réalisation, dans laquelle le plan d'empilement des électrodes est vu de dessus.
**La** **figure 2** reprend le dispositif illustré en figure 1, en vue en coupe selon un plan perpendiculaire au plan de l'empilement, le plan de coupe étant indiqué par les axes A.
**La** **figure 3** reprend le dispositif illustré en figure 1, vu en perspective éclatée du dessus.
**La** **figure 4** est est une vue schématique d'un empilement de butée suivant une variante du premier mode de réalisation, dans laquelle le plan d'empilement des électrodes est vu de dessus.
**La** **figure 5** reprend le dispositif illustré en figure 4, en vue en coupe selon un plan perpendiculaire au plan de l'empilement, le plan de coupe étant indiqué par les axes A.
**La** **figure 6** reprend le dispositif illustré en figure 4, vu en perspective éclatée du dessus.
**La** **figure 7** est est une vue schématique d'un empilement de butée suivant une autre variante du premier mode de réalisation, dans laquelle le plan d'empilement des électrodes est vu de dessus.
**La** **figure 8** reprend le dispositif illustré en figure 7, en vue en coupe selon un plan perpendiculaire au plan de l'empilement, le plan de coupe étant indiqué par les axes A.
**La** **figure 9** reprend le dispositif illustré en figure 7, vu en perspective éclatée du dessus.
**La** **figure 10** est une vue schématique d'un empilement de butée suivant un deuxième mode de réalisation, dans laquelle le plan d'empilement des électrodes est vu de dessus.
**La** **figure 11** reprend le dispositif illustré en figure 10, en vue en coupe selon un plan perpendiculaire au plan de l'empilement, le plan de coupe étant indiqué par les axes A.
**La** **figure 12** reprend le dispositif illustré en figure 10, vu en perspective éclatée du dessus.
**La** **figure 13** est une vue schématique d'un empilement de butée suivant une variante du deuxième mode de réalisation, dans laquelle le plan d'empilement des électrodes est vu de dessus.
**La** **figure 14** reprend le dispositif illustré en figure 13, en vue en coupe selon un plan perpendiculaire au plan de l'empilement, le plan de coupe étant indiqué par les axes A.
**La** **figure 15** reprend le dispositif illustré en figure 13, vu en perspective éclatée du dessus.

### DESCRIPTION DETAILLEE DE MODES DE REALISATION

On a représenté en **figures 1 à 3** un premier mode de réalisation d'un empilement de butée en couches, dans un dispositif MEMS ou NEMS.

L'empilement est vu de dessus en figure 1, selon un axe de vision perpendiculaire à l'empilement. Il est vu de côté en figure 2, en coupe selon un plan perpendiculaire au plan de l'empilement, matérialisé par l'axe A en pointillés sur la figure 1 et par les deux axes A en pointillés de la figure 3. Enfin, il est en perspective éclatée vue du dessus sur la figure 3, qui indique deux directions parallèles à la direction A pour figurer la coupe réalisée en figure 2.

Sur une première couche 1 surjacente, une électrode de gauche 10 comprend une partie gauche plane d'un seul tenant, et une partie droite formant un peigne électrostatique solidaire de la partie gauche. L'électrode de gauche 10 est considérée mobile uniquement selon une première direction matérialisée par l'axe A. En regard de l'électrode de gauche 10, une électrode de droite 11 est de conception semblable, avec une partie droite plane d'un seul tenant et une partie gauche formant deux peignes électrostatiques latéraux symétriques pouvant entrer en interaction électrostatique avec le peigne de l'électrode 10. L'électrode de droite 11 est ici considérée fixe.

Pour ce premier mode de réalisation, lorsque l'on parlera d'un déplacement de l'électrode 10 ou d'un déplacement relatif des deux électrodes 10 et 11, on ne considérera qu'un déplacement selon cette première direction matérialisée par l'axe A. Les deux électrodes 10 et 11 sont, par exemple, fabriquées en silicium. Dans le présent mode de réalisation, elles sont considérées non déformables selon la direction A.

L'électrode de gauche est polarisée différemment de l'électrode de droite, de sorte qu'un contact entre l'une quelconque des extrémités de l'électrode 10 et l'une quelconque des extrémités de l'électrode 11 peut entraîner un court-circuit et/ou une décharge électrostatique, pouvant endommager de manière irréversible l'empilement de butée, voire l'électronique de commande/lecture du fait du court-circuit engendré. Par ailleurs, des risques de défaillance existent même si les électrodes 10 et 11 ne sont pas mises en contact direct, mais sont rapprochées d'une courte distance (de l'ordre du micromètre), suffisamment faible pour créer un champ disruptif dans l'air, et provoquer un phénomène de micro-arcage.

Une couche 3 constitue une couche intermédiaire électriquement isolante. Cette couche est placée sous la couche 1 et n'est visible que sur les figures 2 et 3. Au sein de cette couche, on a placé une surface isolante plane gauche sous la partie gauche plane de l'électrode 10, et une surface isolante plane droite sous la partie droite plane de l'électrode 11. La partie centrale de la couche 1 comprenant une alternance de dents du peigne de l'électrode 10 et du peigne de l'électrode 11 est laissée sans élément isolant sous-jacent dans la couche 3.

Sous la couche 3, est disposée une couche 2 de semi-conducteur. C'est cette sous-couche 2 qui comprend un élément de butée. Un élément mobile plan 20 de gauche est disposé en correspondance de l'électrode de gauche 10. Ici, l'élément mobile plan 20 est de même largeur, selon une direction perpendiculaire à la direction A, que l'électrode 10. L'élément mobile 20 s'étend sur une plus grande distance vers la droite de la figure 1, vers l'électrode 11 en regard, que le bord droit de la partie gauche plane de l'électrode 10. Ainsi, l'élément mobile 20 s'étend vers la droite jusqu'à un élément de butée 24, solidaire de l'élément mobile 20, formant son bord droit externe. L'élément de butée 24 ne s'étend pas nécessairement sur toute la largeur de l'élément mobile 20 et de l'électrode 10.

La butée 24 fait ainsi saillie hors de l'élément mobile 20 dans la direction A. Ici, la butée 24 est située à l'aplomb de l'électrode 10 et notamment du peigne qui fait saillie de ladite électrode. Toutefois, de manière alternative, la butée 24 pourrait faire saillie de l'élément mobile 20 à un emplacement qui ne serait pas situé sous le peigne. La butée 24 pourrait par exemple être située sous la partie gauche pleine de l'électrode 10.

Une autre propriété importante du système est que l'élément mobile 20 est solidaire mécaniquement de l'électrode 10, notamment dans son mouvement de translation selon la direction A. Dans leur mouvement de translation selon cette direction, l'élément mobile 20 et l'électrode 10 sont maintenus par des moyens de suspension 5 implémentes d'une part dans la première couche 1, et d'autre part dans la deuxième couche 2 (mais pas dans la couche isolante 3). Ces moyens de suspension 5 permettent à l'électrode 10 et à l'élément plan 20 de se translater, en restant mécaniquement solidaires, par rapport à une partie fixe du dispositif MEMS située derrière les moyens de suspension 5.

La surface isolante plane gauche de la couche 3 rend ainsi l'électrode 10 solidaire mécaniquement de l'élément mobile 20. Elle crée également une isolation électrique entre l'électrode 10 et l'élément mobile 20, afin d'assurer que les potentiels électriques des éléments 10 et 20 soient indépendants à toute position de l'ensemble formé par les éléments 10 et 20 selon la direction A.

Au sein de la couche 2, en regard de l'élément mobile 20 et notamment de l'élément de butée 24, est agencé un élément mobile plan 21 de droite, disposé en correspondance verticale avec l'électrode de droite 11. De même que pour l'élément mobile 20 de gauche, l'élément mobile 21 s'étend sur une plus grande distance vers la gauche, vers l'électrode 10, que la partie plane droite de l'électrode de droite 11, par son bord gauche 23. L'élément mobile 21 est solidaire de l'électrode 11, notamment dans son mouvement de translation selon la direction A. La surface isolante plane droite de la couche 3 est préférentiellement également solidaire de l'électrode 11 et de l'élément mobile 21.

Le bord gauche 23 se trouve donc en regard de l'élément de butée 24, à une distance D_{B} de l'élément de butée 24 selon la direction A, la distance D_{B} étant ici une première distance d'excursion libre.

La première distance d'excursion libre D_{B} correspond à l'amplitude maximale de déplacement selon la première direction A de la butée 24 par rapport à l'élément mobile 23 (et donc, de l'électrode de gauche 10 par rapport à l'électrode de droite 11). Lors d'un événement de choc qui occasionne un déplacement de l'élément mobile 20 par rapport à l'élément 21 et de l'électrode 10 par rapport à l'électrode 11, l'élément de butée 24 interrompt le rapprochement selon la direction A de ces éléments en venant buter contre le bord droit 23, pour assurer que l'électrode 10 ne soit pas, dans cet état de rapprochement maximal, à une distance de l'électrode 11 plus basse qu'une distance D2. La distance D₂ de rapprochement maximal entre les électrodes tient compté du risque qu'un phénomène de micro-arcage se produise entre des extrémités voisines des deux électrodes 10 et 11. Cette distance D₂ dépend des conditions de mise en œuvre, notamment des niveaux de potentiel mis en œuvre au niveau des électrodes 10 et 11. Elle est typiquement de l'ordre du micromètre. Cette distance D₂ n'est pas visible sur les figures 1 à 3. La distance Dₘᵢₙ minimale entre les électrodes 10 et 11 dans un état non sollicité (donc hors de l'état de rapprochement maximal) est ainsi prise supérieure à la somme de la première distance d'excursion libre D_{B} selon la première direction A, et de la distance D₂ dépendant des conditions de mise en œuvre. Cette distance Dₘᵢₙ entre les électrodes 10 et 11 selon la direction A est, dans le présent exemple, réalisée entre le bord droit de la dent 101 du peigne de l'électrode 10 et le bord gauche de la dent 102 du peigne de l'électrode 11, les références 101 et 102 étant visibles à la figure 2 de la présente demande. Les électrodes pouvant comporter par exemple des peignes électrostatiques classiques de petites dimensions, il peut être nécessaire d'implémenter une distance d'excursion libre très faible, typiquement de l'ordre de 5 microns.

Egalement de manière importante, le contact entre l'élément de butée 24 et le bord gauche 23 de l'élément mobile droit 21 ne doit pas présenter les mêmes risques de court-circuit, de décharge électrostatique ou de collage électrostatique que le contact entre deux extrémités libres des électrodes 10 et 11, comme les extrémités 101 et 102. Dans l'exemple présenté ici, tous les éléments de la sous-couche 2 sont polarisés de la même manière. La couche intermédiaire isolante 3 assure l'indépendance entre les potentiels électriques des éléments de la couche 1 et les potentiels électriques des éléments de la couche 2, bien qu'il existe des dépendances entre les positions selon la direction A de certains de ces éléments.

On a représenté en **figures 4 à 6** une première variante du premier mode de réalisation des figures 1 à 3. De même que pour les figures 1 à 3 : l'empilement est vu de dessus en figure 4, selon un axe de vision perpendiculaire à l'empilement sur le côté en figure 5, en coupe selon un plan perpendiculaire au plan de l'empilement, matérialisé par l'axe A en pointillés, et vu enfin en perspective éclatée vue du dessus sur la figure 6.

La mise en œuvre des couches 1, 2 et 3, des électrodes 10 et 11, et des éléments plans correspondants 20 et 21, est semblable à celle représentée sur les figures 1 à 3. La mise en œuvre de la butée 24 faisant saillie de l'élément plan 20 est également semblable, à ceci près que la butée est rendue flexible par rapport au mode de réalisation précédent. Ici, une cavité 26 est pratiquée à l'ancrage de l'élément de butée 24, avec un léger retrait par rapport au bord externe droit de l'élément plan 20. La cavité 26 n'est pas formée sur toute la largeur de l'élément plan 20, mais elle doit être formée sur une largeur strictement supérieure à celle de l'élément de butée 24, afin d'assurer la mobilité de la butée 24 par rapport à l'élément plan 20 selon la direction A. La cavité 26 forme ainsi, de part et d'autre de la butée 24, deux lames encastrées libres. La butée 24 n'est par ailleurs pas déformable selon une direction perpendiculaire à la direction A (verticale sur la figure), puisqu'elle est maintenue par les deux lames encastrées libres de part et d'autre de la butée 24. La contrebutée (surface 23 en regard de la butée 24), elle, reste indéformable selon la direction A. Il est à noter que la butée flexible 24 est ici formée par deux lames encastrées libres, mais pourrait être mise en œuvre de toute autre manière connue dans les dispositifs électromécaniques (chevron...)

Les deux éléments plans 20 et 21, et avec eux les électrodes 10 et 11 liées mécaniquement auxdits éléments plans, peuvent se rapprocher l'un de l'autre en réponse à une sollicitation, maintenus par les moyens de suspension 5. Si le rapprochement est suffisant, la butée 24 peut rentrer en contact avec la surface 23 en regard, puis les éléments plans 20 et 21 peuvent encore se rapprocher sous l'effet du déplacement vers la gauche de la lame flexible, la cavité 26 étant alors refermée. La cavité 26 n'est formée que dans la deuxième couche plane, puisque la première couche plane n'est pas pleine dans la zone verticalement située au-dessus de la cavité 26 (zone des peignes électrostatiques des électrodes). La cavité 26 est d'une dimension selon la direction A qui correspond à une distance de flèche d'élément plan D_{FP}, telle que représentée en figure 5, correspondant à la déformation maximale de l'élément plan 20 selon la direction A.

Ainsi, en réponse à une sollicitation, les électrodes 10 et 11, et notamment la dent 101 du peigne de l'électrode 10 et la dent 102 du peigne de l'électrode 11, sont susceptibles de se rapprocher d'une distance maximale D_{B} (première distance d'excursion libre) à laquelle on ajoute la distance de flèche d'élément plan D_{FP}. Le dimensionnement de l'empilement est, dans cette variante du premier mode de réalisation, effectué de manière à ce que la distance minimale Dₘᵢₙ dans un état non sollicité entre les électrodes 10 et 11 selon la direction A, réalisée par exemple ici entre les dents 101 et 102, soit supérieure à la somme des distances D_{B} et D_{FP}. Ainsi, on assure que même en cas de sollicitation qui engendrerait un rapprochement des électrodes 10 et 11, les dents 101 et 102 ne sont pas susceptibles de se toucher. On pourrait également tenir compte d'une distance D₂ de micro-arcage, en-deçà de laquelle on estime qu'il existe un risque qu'un arc électrique se forme dans la fine couche de gaz séparant les dents 101 et 102. Dans ce cas, la distance Dₘᵢₙ devrait être prise supérieure à D_{B} + D_{FP} + D₂, afin que même dans un état où les deux électrodes 10 et 11 sont rapprochées, une défaillance liée au micro-arcage soit évitée.

En **figures 7 à 9****,** on a représenté une deuxième variante du premier mode de réalisation des figures 1 à 3. De même que pour les figures 1 à 3 : l'empilement est vu de dessus en figure 7, selon un axe de vision perpendiculaire à l'empilement sur le côté en figure 8, en coupe selon un plan perpendiculaire au plan de l'empilement, matérialisé par l'axe A en pointillés, et vu enfin en perspective éclatée vue du dessus sur la figure 9.

Dans cette variante, la forme des électrodes de la couche 1 et de la butée 24 est semblable à celle décrite en relation aux figures 1 à 3.

De même que pour la première variante décrite ci-avant, on introduit une lame flexible dans la couche 2 pour induire une déformabilité partielle selon la première direction A. Mais à la différence de la première variante décrite en figures 4 à 6, on ne pratique pas une cavité à l'ancrage de la butée 24. Ici, on pratique une cavité 27 dans l'élément plan 21, dans la région faisant face à la butée 24 (c'est-à-dire dans la région de la contrebutée). Avec un léger retrait par rapport au bord externe gauche de l'élément mobile plan 21, on réalise une cavité allongée, sur une largeur selon la direction perpendiculaire à la direction A qui est inférieure à la largeur totale de l'élément plan 21 mais supérieure à la largeur de l'élément de butée 24, de sorte à former une lame bi-encastrée flexible, la partie de l'élément plan 21 située à gauche de la cavité 27 étant déformable selon la première direction A. La lame flexible ainsi formée n'est par ailleurs pas déformable selon une direction perpendiculaire à la direction A (verticale sur la figure), puisque maintenue par les bords de la cavité 27. La butée 24 demeure, elle, indéformable selon la direction A.

Les deux éléments plans 20 et 21, et avec eux les électrodes 10 et 11 (liées mécaniquement auxdits éléments plans) peuvent là encore se rapprocher l'un de l'autre en réponse à une sollicitation, maintenus par les moyens de suspension 5. Si le rapprochement est suffisant, la butée 24 peut rentrer en contact avec la surface 23 en regard, puis les éléments plans 20 et 21 peuvent encore se rapprocher sous l'effet du déplacement vers la droite de la lame flexible, la cavité 27 étant alors refermée. La cavité 27 n'est là encore formée que dans la deuxième couche 2, et est d'une dimension qui correspond à une distance de flèche d'élément plan D_{FP}, telle que représentée en figure 5. Cette distance de flèche d'élément plan représente la déformation maximale de l'élément plan 21 selon la direction A.

Ainsi, en réponse à une sollicitation, les électrodes 10 et 11, et notamment la dent 101 du peigne de l'électrode 10 et la dent 102 du peigne de l'électrode 11, sont susceptibles de se rapprocher d'une distance maximale D_{B} (première distance d'excursion libre) à laquelle on ajoute la distance de flèche d'élément plan D_{FP}. La distance minimale Dₘᵢₙ dans un état non sollicité entre les électrodes 10 et 11 selon la direction A, réalisée par exemple ici entre les dents 101 et 102, est supérieure à la somme des distances D_{B} et D_{FP}. Si l'on veut, de manière optionnelle, tenir compte des risques de défaillance liés à un micro-arcage, on peut définir une distance D₂ minimale entre les extrémités d'électrodes, en-deçà de laquelle ledit risque existe. On dimensionnerait alors l'empilement de sorte à avoir Dₘᵢₙ supérieur à la somme D_{B} + D_{FP} + D₂.

On a représenté en **figures 10 à 12** un deuxième mode de réalisation d'un empilement en couches, où la mise en œuvre des électrodes et des butées est différente par rapport à toutes les figures précédemment décrites. On représente ici des électrodes 10' et 11'.

L'empilement est vu de dessus en figure 10, selon un axe de vision perpendiculaire à l'empilement. Il est vu de côté en figure 11, en coupe selon un plan perpendiculaire au plan de l'empilement, matérialisé par l'axe A en pointillés sur la figure 10 et par les deux axes A en pointillés de la figure 12. Enfin, il est vu en perspective éclatée du dessus sur la figure 12, qui indique deux directions parallèles à la direction A pour figurer la coupe réalisée en figure 11.

Les références numériques utilisées sur les figures 1 à 3 et définies ci-avant peuvent être réutilisées dans les figures 10 à 12 pour désigner des éléments correspondants dans l'empilement selon le deuxième mode de réalisation.

Ce deuxième mode de réalisation diffère notamment du premier mode de réalisation en ce que les électrodes 10' et 11' de la couche 1 et les éléments plans 20 et 21 correspondants sont pris partiellement déformables selon la première direction A. On propose ici une implémentation avantageuse pour que les peignes électrostatiques des électrodes visibles sur les figures 10 à 12 soient mobiles selon la direction A par rapport au reste des électrodes qui les portent.

Par ailleurs, ce deuxième mode de réalisation diffère aussi du premier mode en ce que les électrodes 10' et 11', et notamment les peignes électrostatiques, sont mobiles l'un par rapport à l'autre selon une deuxième direction B perpendiculaire à la direction A, contenue dans le plan des électrodes 10' et 11'. Par exemple, des moyens de suspension non représentés sur les figures, par exemple semblables aux moyens de suspension 5, peuvent permettre la mobilité des électrodes 10' et 11' selon la direction B.

L'électrode de gauche 10' de la couche 1 comprend ici une partie plane gauche et un peigne électrostatique sur une partie droite. De manière symétrique, l'électrode de droite 11' comprend une partie plane droite et un peigne électrostatique sur une partie gauche. Les deux peignes électrostatiques correspondant respectivement aux électrodes 10' et 11' sont agencés de telle manière que, dans un état non sollicité, leurs dents s'imbriquent sans se toucher, et notamment sans se toucher selon la première direction A ni selon la deuxième direction B.

L'électrode de gauche 10' diffère de l'électrode de gauche 10 du mode de réalisation précédent en ce que sa partie plane gauche est percée d'une cavité débouchante 12 de forme rectangulaire. Elle est dite débouchante, au sens où elle est pratiquée sur toute l'épaisseur de l'empilement, dans la les trois couches 1, 2 et 3. Ce mode de réalisation diffère ainsi, de manière importante, des modes de réalisation correspondant aux figures 4 à 9, dans lesquels une cavité n'est pratiquée que dans la couche 2 inférieure, les électrodes 10 et 11 étant ainsi non déformables selon la direction A. La cavité débouchante 12 est pratiquée au voisinage du bord externe droit 14 de la partie plane gauche de l'électrode 10', mais en ménageant un certain retrait par rapport au bord 14. Cette cavité permet au bord externe 14 de constituer une lame flexible. La lame flexible peut réagir à un événement vibratoire subi par l'électrode 10' en se déplaçant en translation selon la direction A, sur une amplitude maximale qui correspond à une distance de flèche d'électrode D_{FE}, ainsi qu'à une distance de flèche d'élément plan D_{FP} (puisque à la fois une partie de l'électrode 10' et une partie de l'élément plan 20 sont déformables au niveau de la lame flexible). Lorsque la lame flexible 14 se déplace selon une telle translation, le matériau de la partie de l'électrode 10' formant peigne électrostatique n'étant par ailleurs pas déformable selon la direction A, le peigne électrostatique est susceptible de se déplacer également en translation selon la direction A sur une amplitude qui ne dépasse pas la distance de flèche d'électrode D_{FE}. La lame flexible 14 n'est par ailleurs pas déformable selon la direction B, puisque maintenue par les bords de la cavité débouchante 12.

De manière tout à fait semblable, l'électrode de droite 11' est dotée, sur le bord externe gauche de sa partie plane droite, d'une cavité débouchante 13 qui donne lieu à une lame flexible 15. La lame flexible 15 est, de même que la lame flexible 14, déformable en translation selon la direction A, d'une amplitude maximale égale à la distance de flèche d'électrode D_{FE}.

La distance Dₘᵢₙ entre les électrodes 10' et 11' selon la direction A est, dans ce deuxième exemple, réalisée entre le bord droit de la dent 101' du peigne de l'électrode 10' et le bord gauche de la dent 102' du peigne de l'électrode 11', les références 101' et 102' étant visibles à la figure 11. Les électrodes 10' et 11' étant polarisées différemment comme dans l'exemple précédent, il est primordial qu'elles ne soient pas en contact au risque de compromettre la fonctionnalité électromécanique du système. On peut éventuellement considérer qu'il ne suffit pas d'éviter que les électrodes entrent en contact, et qu'il faut de surcroît éviter que leurs extrémités ne soient trop proches (de l'ordre du micromètre de distance, par exemple) pour éviter des phénomènes de micro-arcage. La couche intermédiaire 2 assure ici un rôle d'isolation électrique semblable à celui qu'elle joue dans l'exemple qui précède. Enfin, la couche 3 comprend, de manière semblable à l'exemple précédent, un élément de butée qui assure que les électrodes 10' et 11' ne soient pas susceptibles de rentrer en contact lors d'un événement vibratoire ou de choc, susceptible de mettre en mouvement les électrodes 10' et 11' l'une par rapport à l'autre selon la première direction A.

La sous-couche 2 est ici représentée avec un agencement différent de l'exemple précédent. La sous-couche 2 comprend toujours un élément plan de gauche 20' solidaire de l'électrode 10' et un élément plan de droite 21' solidaire de l'électrode 11', tels que les éléments plans 20' et 21' sont mobiles l'un par rapport à l'autre selon la première direction A.

A la différence de l'élément plan de gauche 20 illustré sur les figures 1 à 3, l'élément plan de gauche 20' de cet exemple change de largeur au voisinage du bord externe 14 de l'électrode 10'. Il présente une branche 24 formant élément de butée, s'étendant jusqu'à une extrémité droite d'élément de butée 22'. L'élément de butée 24 n'est pas, à l'image de l'exemple précédent, en position centrale dans la zone située entre l'élément plan de gauche et l'élément plan de droite dans la sous-couche 2, mais est situé sur le bord droit de la branche 24 qui est légèrement en retrait par rapport au bord 23 en regard de l'élément plan de droite 21'.

Comme cela est visible en figure 10, l'élément de butée 24 et notamment son extrémité 22' se trouvent dans le prolongement selon la première direction A de la cavité débouchante 12, mais pas dans le prolongement de la cavité débouchante 13, de sorte que face à l'extrémité 22' se situe une partie non déformable de l'élément de droite 21'. De plus, la largeur de la cavité débouchante 12 (selon la direction B) est supérieure à celle de la butée 24. Ainsi, l'ancrage de la butée 24 correspond à une lame flexible selon la direction A, mais son extrémité 22' ne fait pas face à une lame flexible.

De manière symétrique, l'élément de droite 21' présente un élément de butée 25 s'étendant à partir du bord correspondant verticalement au bord externe 15 de l'électrode 11', et dans le prolongement de la cavité débouchante 13, et présente une extrémité d'élément de butée faisant face à un bord non déformable de l'élément de gauche 20'. L'empilement de butée selon le deuxième mode de réalisation comporte donc deux éléments de butée 24 et 25.

La distance entre l'élément de butée 24 et le bord 23' de l'élément plan de droite 21' en regard, ou entre l'élément de butée 25 et le bord de l'élément plan de gauche 20' en regard, correspondent à une première distance d'excursion libre D_{B}, de même signification que la première distance d'excursion libre D_{B} de l'exemple précédent. On notera par ailleurs ici que la distance de flèche d'électrode D_{FE} (déformation maximale totale au niveau des électrodes) qui est la distance de flèche attribuable aux cavités 12 et 13 dans la couche 1, et la distance de flèche d'élément plan D_{FP} (déformation maximale totale au niveau des éléments de butée) , qui est la distance de flèche attribuable aux cavités 12 et 13 dans la couche 2, sont égales. Les cavités débouchantes 12 et 13 sont de dimensions constantes sur toute l'épaisseur de l'empilement : l'ancrage des peignes électrostatiques est déformable selon la direction A de la même longueur que l'ancrage des butées.

De manière importante, la première distance d'excursion libre D_{B}, qui correspond à l'amplitude maximale de déplacement selon la première direction A de l'extrémité 22' par rapport à l'élément en regard 23' (et donc, de l'électrode de gauche 10' par rapport à l'électrode de droite 11'), est telle que la somme de cette distance d'excursion libre et de l'amplitude maximale de déformation (distance de flèche d'électrode D_{FE}) des deux électrodes 10' et 11' l'une par rapport à l'autre soit inférieure à la distance minimale selon la direction A entre l'électrode de gauche 10' et l'électrode de droite 11'.

Ainsi, lorsque les deux électrodes 10' et 11' se rapprochent sous l'effet d'une force interne (force électrostatique) ou externe (accélération, choc), les dents des peignes électrostatiques, (par exemple, les dents 101' et 102') se rapprochent d'abord jusqu'à une distance qui correspond à l'excursion libre des éléments de butée 24 et 25. Puis si le rapprochement se poursuit, la base de l'élément de butée 24 peut, sous l'effet de l'appui de l'extrémité 22' opposée de la butée 24, appuyer contre la lame flexible 14 située à l'ancrage de la butée 24, et induire un fléchissement des dents du peigne de 10'.

Le critère de dimensionnement appliqué ici est donc plus restrictif que celui de l'exemple précédent, car dans le dimensionnement de la distance minimale entre les deux électrodes 10' et 11' selon la première direction A, on prend en compte non seulement la première distance d'excursion libre des électrodes 10' et 11' permise par l'agencement de la butée 24, mais aussi l'amplitude maximale de déformation relative des deux peignes électrostatiques faisant saille respectivement des électrodes 10' et 11'. Ainsi, la distance Dₘᵢₙ entre les deux électrodes 10' et 11' selon la première direction A, représentée ici entre la dent 101' du peigne de l'électrode 10' et la dent 102' du peigne de l'électrode 11', doit être supérieure à D_{FE} + D_{B}. Si l'on souhaite tenir compte de risques de micro-arcage entre les dents des peignes électrostatiques des électrodes 10' et 11', on peut définir une distance D₂ minimale entre les extrémités d'électrodes, en-deçà de laquelle ce risque existe. On dimensionnerait alors l'empilement de sorte à avoir Dₘᵢₙ supérieur à la somme D_{B} + D_{FP} + D₂.

Un effet de ce dimensionnement est de permettre, lors d'un événement de choc qui occasionne un déplacement de l'élément mobile 20' par rapport à l'élément 21' et de l'électrode 10' par rapport à l'électrode 11', que l'élément de butée 24 interrompe le rapprochement selon la direction A de ces éléments en venant buter contre le bord droit 23', avant que l'électrode 10' ne puisse être suffisamment proche de l'électrode 11' pour générer une décharge électrostatique ou des micro-arcs électriques, et endommager le dispositif MEMS.

Par ailleurs, comme il a été mentionné ci-avant, les électrodes 10' et 11' sont mobiles l'une par rapport à l'autre non seulement selon la première direction A, mais aussi selon la deuxième direction B ici prise perpendiculaire à la première direction A. Les deux éléments de butée 24 et 25, dont la forme et le positionnement par rapport aux éléments plans 20' et 21' ont été décrits ci-avant, sont distants l'un de l'autre selon cette deuxième direction B, ménageant une deuxième distance d'excursion libre D_{B}' selon la direction B.

L'empilement est alors agencé de telle sorte que dans l'état non sollicité, la première électrode 10' se trouve à une distance Dₘᵢₙ' par rapport à la deuxième électrode 11' selon la deuxième direction B qui soit supérieure à cette deuxième distance d'excursion libre D_{B}', de sorte que les deux électrodes ne puissent pas non plus être mises en contact par un rapprochement selon la deuxième direction B.

Un deuxième critère de dimensionnement Dₘᵢₙ' > D_{B}' est donc ici pris en compte, en complément du critère qui régit le déplacement maximal des électrodes et leur dimensionnement selon la première direction A.

Un avantage de ce deuxième mode de réalisation avec déformabilité partielle des électrodes est d'être utilisable pour des dispositifs susceptibles de subir de grandes amplitudes de déplacement vis-à-vis de l'entrefer des électrodes suite à un événement de choc. En particulier, les MEMS visant des applications de hautes performances nécessitent des entrefers de faibles dimensions et des masses élevées, typiquement les capteurs inertiels, qui engendrent une grande amplitude de déplacement suite à un événement de choc, comparativement à l'entrefer des électrodes.

On a représenté en **figures 13 à 15** une variante du deuxième mode de réalisation des figures 10 à 12.

L'empilement est vu de dessus en figure 13, selon un axe de vision perpendiculaire à l'empilement. Il est vu de côté en figure 14, en coupe selon un plan perpendiculaire au plan de l'empilement, matérialisé par l'axe A en pointillés sur la figure 13 et par les deux axes A en pointillés de la figure 15. Enfin, il est vu en perspective éclatée du dessus sur la figure 15, qui indique deux directions parallèles à la direction A pour figurer la coupe réalisée en figure 14.

Dans cette variante du deuxième mode de réalisation, la forme des électrodes de la couche 1 est semblable à celle décrite ci-avant en relation avec les figures 10 à 12. La forme des butées 24 et 25, au sein de la couche 2, est également inchangée.

Cependant, dans cette variante, seule l'électrode 11' est partiellement déformable selon la première direction A, le peigne électrostatique de cette électrode étant mobile selon la direction A par rapport à sa base. Par ailleurs, les électrodes 10' et 11' restent mobiles l'une par rapport à l'autre selon une deuxième direction B perpendiculaire à la direction A, contenue dans le plan de ces électrodes. Précisément, la cavité débouchante 12 décrite en relation aux figures 10 à 12, pratiquée dans l'électrode 10' et dans les couches sous-jacentes, n'est plus pratiquée ici. La cavité débouchante 13 des figures 10 à 12 n'est pas présente dans la variante des figures 13 à 15. L'empilement ici décrit comprend deux cavités débouchantes 13' et 13" pratiquées avec un même retrait par rapport au bord externe gauche de l'électrode 11', de largeur selon la direction B supérieure à celle des extrémités des éléments de butée 24 et 25 de sorte à former deux lames flexibles 15' et 15" selon la première direction A.

La cavité débouchante 13' est située en regard de l'extrémité 22' de l'élément de butée 24 (la forme de l'élément de butée 24 étant identique à celle du deuxième mode de réalisation ici exposé). La cavité débouchante 13", elle, est pratiquée à l'ancrage de l'élément de butée 25. Les deux cavités débouchantes 13' et 13", et donc les deux lames flexibles 15' et 15", sont indépendantes et séparées par une cloison rigide. Par ailleurs, les éléments de butée longilignes 24 et 25 sont inchangés par rapport au deuxième mode de réalisation ci-avant.

Ainsi, lorsque les deux électrodes 10' et 11' se rapprochent selon la première direction A sous l'effet d'une contrainte mécanique extérieure, les dents des peignes électrostatiques (par exemple, les dents 101' et 102') se rapprochent d'abord jusqu'à une distance qui correspond à la première distance d'excursion libre D_{B} des éléments de butée 24 et 25, comme dans la première implémentation du deuxième mode de réalisation.

En revanche, le comportement des dents de peignes électrostatiques diffère lorsque le rapprochement selon la première direction A se poursuit : la base de l'élément de butée 24 ne peut plus induire un fléchissement des dents du peigne de 10', en l'absence de la cavité débouchante 12 du mode de mise en œuvre des figures 10 à 12.

A la place, la présence d'une nouvelle cavité débouchante 13' en face de l'extrémité 22' de l'élément de butée, cavité pratiquée dans le corps de l'électrode 11' en regard, fait que l'extrémité 22' de la butée 24 peut appuyer contre la lame flexible 15', pour que la butée 24 continue sa progression vers l'électrode 11' selon la première direction A. Ainsi, les dents du peigne de 10' peuvent être fléchies en sens inverse du sens de fléchissement obtenu pour le deuxième mode de réalisation. Le fléchissement obtenu dans ce troisième mode de réalisation n'est, contrairement à celui obtenu dans le deuxième mode, pas de nature à rapprocher les dents des peignes électrostatiques comme par exemple les dents 101' et 102'.

Le critère de dimensionnement appliqué ici est ainsi moins restrictif que celui de l'exemple précédent. On prend en compte la première distance d'excursion libre des électrodes 10' et 11' permise par l'agencement des butées 24 et 25. La distance Dₘᵢₙ entre les deux électrodes 10' et 11' selon la première direction A, représentée ici entre la dent 101' du peigne de l'électrode 10' et la dent 102' du peigne de l'électrode 11', doit être supérieure à D_{B}. On peut éventuellement, de manière similaire aux variantes présentées ci-avant, tenir compte du risque de micro-arcage entre les électrodes, auquel cas on peut prendre une distance minimale Dₘᵢₙ à l'état non sollicité entre les électrodes 10' et 11' supérieure à la somme de la première distance d'excursion libre D_{B} des électrodes, et d'une distance D₂ en-deçà de laquelle on estime qu'un risque de micro-arcage existe. Dans ce cas, la distance minimale Dₘᵢₙ entre les extrémités d'électrodes à l'état non sollicité est prise supérieure à la somme D_{B} + D₂.

De plus, les électrodes 10' et 11' étant, là encore, mobiles l'une par rapport à l'autre non seulement selon la première direction A, mais aussi selon la deuxième direction B, le positionnement relatif des deux éléments de butée 24 et 25 selon cette deuxième direction B fait aussi l'objet d'un critère de dimensionnement supplémentaire.

Si on note à nouveau D_{B}' la deuxième distance d'excursion libre entre les deux éléments de butée 24 et 25 selon cette deuxième direction B, on agence l'empilement de telle sorte que dans l'état non sollicité, la première électrode 10' se trouve à une distance Dₘᵢₙ' par rapport à la deuxième électrode 11' selon la deuxième direction B qui soit supérieure à cette deuxième distance d'excursion libre D_{B}'.

On conserve donc le deuxième critère de dimensionnement Dₘᵢₙ' > D_{B}' du deuxième mode de réalisation.

Il convient de noter que, si les exemples illustratifs ici décrits donnent à voir une couche comprenant les électrodes, réalisant la fonctionnalité électromécanique attendue du système, empilée au-dessus de la couche comprenant un élément de butée pour empêcher un contact physique des électrodes, un autre agencement où la couche comprenant les électrodes serait en-dessous de la couche comprenant les éléments de butée peut être envisagé.

## Revendications

1. Dispositif MEMS ou NEMS de type capteur ou actionneur, doté d'un empilement de butée comprenant :
- une première couche plane (1) comprenant une première électrode plane (10) étant, en fonctionnement du dispositif, à un premier potentiel électrique et une deuxième électrode plane (11) étant, en fonctionnement du dispositif, à un deuxième potentiel électrique distinct du premier potentiel,
la première électrode plane (10) étant mobile relativement à la deuxième électrode plane (11) selon une première direction (A) parallèle à la première couche plane,
- une deuxième couche plane (2) superposée à la première couche plane (1), isolée électriquement de la première couche plane (1) par au moins une couche intermédiaire (3) formée en matériau isolant, la deuxième couche plane (2) comprenant un premier élément plan (20) solidaire mécaniquement de la première électrode plane (10), et un deuxième élément plan (21) solidaire mécaniquement de la deuxième électrode plane (11),
- au moins un élément de butée (24) s'étendant du premier élément plan (20) ou du deuxième élément plan (21) selon la première direction (A) et faisant saillie par rapport audit élément plan dans la première direction (A),
l'élément de butée (24) et les électrodes étant configurés pour que l'élément de butée (24) vienne en contact avec la surface en regard (23) et bloque le rapprochement des deux électrodes planes (10, 11) selon la première direction (A) lors d'une sollicitation,
**caractérisé en ce que** l'élément de butée (24) qui s'étend à partir d'un des éléments plans est, en fonctionnement du dispositif, au même potentiel qu'une surface en regard (23) appartenant à l'autre des éléments plans (21).

2. Dispositif MEMS ou NEMS selon la revendication 1, dans lequel l'élément de butée et les électrodes sont configurés de telle sorte que dans l'état non sollicité, toute extrémité libre (101) de la première électrode plane (10) se trouve, par rapport à une extrémité la plus proche de la deuxième électrode plane (102) selon la première direction (A), à une distance minimale (Dₘᵢₙ) supérieure à une première distance d'excursion libre (D_{B}), ladite distance étant définie comme la distance minimale entre l'élément de butée (24) et la surface en regard.

3. Dispositif MEMS ou NEMS selon la revendication 2, dans lequel la distance minimale (Dₘᵢₙ) est supérieure à la somme de la première distance d'excursion libre (D_{B}) et d'une deuxième distance prédéterminée, en-deçà de laquelle il existe un risque de perte du caractère isolant du gaz environnant les électrodes (10, 11), de sorte qu'un court-circuit peut s'établir entre deux extrémités des électrodes (101, 102).

4. Dispositif MEMS ou NEMS selon l'une quelconque des revendications 1 à 3, dans lequel au moins une première électrode plane (11') est au moins partiellement déformable suivant la première direction (A), la somme des déformations maximales possibles selon la première direction (A) des électrodes (10', 11') définissant une distance de flèche d'électrode (D_{FE}), la distance minimale (Dₘᵢₙ) étant prise supérieure à la somme de la première distance d'excursion libre (D_{B}) et de la distance de flèche d'électrode (D_{FE}).

5. Dispositif MEMS ou NEMS selon l'une quelconque des revendications 1 à 4, dans lequel au moins un premier élément plan (20) est au moins partiellement déformable suivant la première direction (A), la somme des déformations maximales possibles selon la première direction (A) des éléments plans (20, 21) définissant une distance de flèche d'élément plan (D_{FP}) donnée, la distance minimale (Dₘᵢₙ) étant prise supérieure à la somme de la première distance d'excursion libre (D_{B}) et de la distance de flèche d'élément plan (D_{FP}).

6. Dispositif MEMS ou NEMS selon la revendication 5, dans lequel l'un au moins des deux éléments plans (20, 21) est partiellement déformable selon la première direction (A),
la deuxième couche plane (2) étant percée d'une cavité (26) pratiquée à l'ancrage de l'élément de butée (24), et/ou étant percée d'une cavité (27) pratiquée le long d'un bord externe de la surface (23) en regard de l'élément de butée (24),
la distance de flèche (D_{FP}) d'élément plan étant définie comme la somme des dimensions selon la première direction (A) des deux cavités (26, 27) ou, le cas échéant, définie comme la dimension selon la première direction de l'unique cavité, pratiquée(s) dans la deuxième couche plane (2).

7. Dispositif MEMS ou NEMS selon la revendication 4 et la revendication 5 prises en combinaison, dans lequel les deux électrodes planes (10', 11') et les deux éléments plans (20, 21) sont déformables selon la première direction (A), le premier élément plan (21) portant un premier élément de butée (25) et le deuxième élément plan (20) portant un deuxième élément de butée (24),
une première cavité débouchante (13) étant pratiquée sur toute la hauteur de l'empilement à l'ancrage du premier élément de butée (25), et en correspondance selon la première direction (A) avec ledit premier élément de butée (25), mais pas en correspondance selon la première direction (A) avec le deuxième élément de butée (24), formant une première lame flexible (14),
une deuxième cavité débouchante (12) étant pratiquée sur toute la hauteur de l'empilement à l'ancrage du deuxième élément de butée (24), et en correspondance selon la première direction (A) avec ledit deuxième élément de butée (24), mais pas en correspondance selon la première direction (A) avec le premier élément de butée (25), formant une deuxième lame flexible (15),
la première distance d'excursion libre (D_{B}) étant définie comme la distance minimale entre le premier élément de butée (25) et la surface en regard, la distance de flèche d'électrode (D_{FE}) étant définie comme la somme des dimensions selon la première direction (A) des deux cavités débouchantes (12, 13).

8. Dispositif MEMS ou NEMS selon la revendication 4 et la revendication 5 prises en combinaison, dans lequel le premier élément plan (21) porte un premier élément de butée (25) et le deuxième élément plan (20) porte un deuxième élément de butée (24),
et dans lequel une première cavité débouchante (13') est pratiquée sur toute la hauteur de l'empilement dans la première électrode plane (11'), en correspondance selon la première direction (A) avec une extrémité (22') du deuxième élément de butée (24) en regard, formant une première lame flexible (15'),
et une deuxième cavité débouchante (13") est pratiquée sur toute la hauteur de l'empilement dans la première électrode plane (11'), à l'ancrage du premier élément de butée (25) selon la première direction (A), et en correspondance selon la première direction (A) avec ledit premier élément de butée (25), formant une deuxième lame flexible (15"),
la première distance d'excursion libre (D_{B}) étant définie comme la distance minimale entre le premier élément de butée (25) et la surface en regard.

9. Dispositif MEMS ou NEMS selon l'une des revendications 1 à 8, dans lequel les deux électrodes planes sont en outre mobiles l'une par rapport à l'autre selon une deuxième direction (B) sensiblement perpendiculaire à la première direction (A),
la deuxième direction (B) étant parallèle à la couche plane (1) contenant les électrodes,
et dans lequel le premier élément plan (21) porte un premier élément de butée (25) et le deuxième élément plan (20) porte un deuxième élément de butée (24), l'empilement étant configuré de telle sorte que dans l'état non sollicité, toute extrémité libre de la première électrode plane (11') se trouve, par rapport à la deuxième électrode plane (10') selon la deuxième direction (B), à une distance minimale (Dₘᵢₙ') supérieure à une deuxième distance d'excursion libre (D_{B}'), la deuxième distance d'excursion libre (D_{B}') étant définie comme la distance minimale entre les premier et deuxième éléments de butée (24, 25) selon la deuxième direction (B).

10. Dispositif MEMS ou NEMS selon l'une quelconque des revendications précédentes, dont une électrode comprend une plaque plane et/ou dont une électrode comprend un peigne électrostatique.

## Patentansprüche

1. MEMS- oder NEMS-Vorrichtung vom Typ Sensor oder Aktuator, der mit einer Anschlagstapelung versehen ist, die umfasst:
- eine erste ebene Schicht (1), die eine erste ebene Elektrode (10), die sich beim Betrieb der Vorrichtung auf einem ersten elektrischen Potential befindet, und eine zweite ebene Elektrode (11) umfasst, die sich beim Betrieb der Vorrichtung auf einem zweiten elektrischen Potential befindet, das sich von dem ersten Potential unterscheidet,
wobei die erste ebene Elektrode (10) in Bezug auf die zweite ebene Elektrode (11) entlang einer ersten Richtung (A) parallel zur ersten ebenen Schicht beweglich ist,
- eine zweite ebene Schicht (2), die auf der ersten ebenen Schicht (1) überlagert ist und durch mindestens eine Zwischenschicht (3), die aus isolierendem Material gebildet ist, von der ersten ebenen Schicht (1) elektrisch isoliert ist, wobei die zweite ebene Schicht (2) ein erstes ebenes Element (20), das mechanisch mit der ersten ebenen Elektrode (10) fest verbunden ist, und ein zweites ebenes Element (21) umfasst, das mechanisch mit der zweiten ebenen Elektrode (11) fest verbunden ist,
- mindestens ein Anschlagelement (24), das sich von dem ersten ebenen Element (20) oder von dem zweiten ebenen Element (21) entlang der ersten Richtung (A) erstreckt und in Bezug auf das ebene Element in der ersten Richtung (A) hervorsteht,
wobei das Anschlagelement (24) und die Elektroden so ausgestaltet sind, dass das Anschlagelement (24) mit der gegenüberliegenden Oberfläche (23) in Kontakt gelangt und die Annäherung der zwei ebenen Elektroden (10, 11) entlang der ersten Richtung (A) bei einer Beanspruchung blockiert, **dadurch gekennzeichnet, dass** das Anschlagelement (24), das sich ausgehend von einem der ebenen Elemente erstreckt, sich beim Betrieb der Vorrichtung auf dem gleichen Potential befindet wie eine gegenüberliegende Oberfläche (23), die zu dem anderen von den ebenen Elementen (21) gehört.

2. MEMS- oder NEMS-Vorrichtung nach Anspruch 1, wobei das Anschlagelement und die Elektroden derart ausgestaltet sind, dass im nicht beanspruchten Zustand jedes freie Ende (101) der ersten ebenen Elektrode (10) sich in Bezug auf ein nächstes Ende der zweiten ebenen Elektrode (102) entlang der ersten Richtung (A) in einem Mindestabstand (Dₘᵢₙ) befindet, der größer als ein erster freier Auslenkungsabstand (D_{B}) ist, wobei der Abstand als der Mindestabstand zwischen dem Anschlagelement (24) und der gegenüberliegenden Oberfläche definiert ist.

3. MEMS- oder NEMS-Vorrichtung nach Anspruch 2, wobei der Mindestabstand (Dₘᵢₙ) größer als die Summe des ersten freien Auslenkungsabstands (D_{B}) und eines zweiten vorbestimmten Abstands ist, unterhalb dem eine Gefahr des Verlustes der isolierenden Eigenschaft des Gases besteht, das die Elektroden (10, 11) umgibt, derart, dass ein Kurzschluss zwischen den zwei Enden der Elektroden (101, 102) entstehen kann.

4. MEMS- oder NEMS-Vorrichtung nach einem der Ansprüche 1 bis 3, wobei die mindestens eine ebene Elektrode (11') zumindest teilweise entlang der ersten Richtung (A) verformbar ist, wobei die Summe der möglichen Höchstverformungen entlang der ersten Richtung (A) der Elektroden (10', 11') einen Durchbiegungsabstand der Elektrode (D_{FE}) definiert, wobei der Mindestabstand (Dₘᵢₙ) größer als die Summe des ersten freien Auslenkungsabstands (D_{B}) und des Elektrodendurchbiegungsabstands (D_{FE}) genommen wird.

5. MEMS- oder NEMS-Vorrichtung nach einem der Ansprüche 1 bis 4, wobei mindestens ein erstes ebenes Element (20) zumindest teilweise entlang der ersten Richtung (A) verformbar ist, wobei die Summe der möglichen Höchstverformungen entlang der ersten Richtung (A) der ebenen Elemente (20, 21) einen gegebenen Durchbiegungsabstand (D_{FP}) des ebenen Elements definiert, wobei der Mindestabstand (Dₘᵢₙ) größer als die Summe des ersten freien Auslenkungsabstands (D_{B}) und des Durchbiegungsabstands des ebenen Elements (D_{FP}) genommen wird.

6. MEMS- oder NEMS-Vorrichtung nach Anspruch 5, wobei mindestens eines der zwei ebenen Elemente (20, 21) teilweise entlang der ersten Richtung (A) verformbar ist,
wobei die zweite ebene Schicht (2) durch einen Hohlraum (26) durchbohrt ist, der an der Verankerung des Anschlagelements (24) angeordnet ist, und/oder durch einen Hohlraum (27) durchbohrt ist, der entlang eines äußeren Randes der Oberfläche (23) dem Anschlagelement (24) gegenüberliegend angeordnet ist,
wobei der Durchbiegungsabstand (D_{FP}) des ebenen Elements als die Summe der Abmessungen der zwei Hohlräume (26, 27) entlang der ersten Richtung (A) definiert ist oder gegebenenfalls als die Abmessung des einzigen Hohlraums entlang der ersten Richtung definiert ist, der/die in der zweiten ebenen Schicht (2) angeordnet ist/sind.

7. MEMS- oder NEMS-Vorrichtung nach Anspruch 4 und Anspruch 5 in Kombination, wobei die zwei ebenen Elektroden (10', 11') und die zwei ebenen Elemente (20, 21) entlang der ersten Richtung (A) verformbar sind, wobei das erste ebene Element (21) ein erstes Anschlagelement (25) trägt und das zweite ebene Element (20) ein zweites Anschlagelement (24) trägt,
ein erster offener Hohlraum (13) über die gesamte Höhe der Stapelung an der Verankerung des ersten Anschlagelements (25) und entlang der ersten Richtung (A) dem ersten Anschlagelement (25) entsprechend, aber nicht entlang der ersten Richtung (A) dem zweiten Anschlagelement (24) entsprechend angeordnet ist, wodurch ein erster biegsamer Streifen (14) gebildet wird,
ein zweiter offener Hohlraum (12) über die gesamte Höhe der Stapelung an der Verankerung des zweiten Anschlagelements (24) und entlang der ersten Richtung (A) dem zweiten Anschlagelement (24) entsprechend aber nicht entlang der ersten Richtung (A) dem ersten Anschlagelement (25) entsprechend angeordnet ist, wodurch ein zweiter biegsamer Streifen (15) gebildet wird,
wobei der erste freie Auslenkungsabstand (D_{B}) als der Mindestabstand zwischen dem ersten Anschlagelement (25) und der gegenüberliegenden Oberfläche definiert ist, wobei der Elektrodendurchbiegungsabstand (D_{FE}) als die Summe der Abmessungen der zwei offenen Hohlräume (12, 13) entlang der ersten Richtung (A) definiert ist.

8. MEMS- oder NEMS-Vorrichtung nach Anspruch 4 und Anspruch 5 in Kombination, wobei das erste ebene Element (21) ein erstes Anschlagelement (25) trägt und das zweite ebene Element (20) ein zweites Anschlagelement (24) trägt,
und wobei ein erster offener Hohlraum (13') über die gesamte Höhe der Stapelung in der ersten ebenen Elektrode (11') einem Ende (22') des zweiten gegenüberliegenden Anschlagelements (24) entlang der ersten Richtung (A) entsprechend angeordnet ist, wodurch ein erster biegsamer Streifen (15') gebildet wird,
und ein zweiter offener Hohlraum (13") über die gesamte Höhe der Stapelung in der ersten ebenen Elektrode (11'), an der Verankerung des ersten Anschlagelements (25) entlang der ersten Richtung (A) und dem ersten Anschlagelement (25) entlang der ersten Richtung (A) entsprechend angeordnet ist, wodurch ein zweiter biegsamer Streifen (15") gebildet wird,
wobei der erste freie Auslenkungsabstand (D_{B}) als der Mindestabstand zwischen dem ersten Anschlagelement (25) und der gegenüberliegenden Oberfläche definiert ist.

9. MEMS- oder NEMS-Vorrichtung nach einem der Ansprüche 1 bis 8, wobei die zwei ebenen Elektroden ferner in Bezug aufeinander entlang einer zweiten Richtung (B) im Wesentlichen senkrecht zu der ersten Richtung (A) beweglich sind,
wobei die zweite Richtung (B) parallel zur ebenen Schicht (1) ist, die die Elektroden enthält,
und wobei das erste ebene Element (21) ein erstes Anschlagelement (25) trägt und das zweite ebene Element (20) ein zweites Anschlagelement (24) trägt,
wobei die Stapelung derart ausgestaltet ist, dass im nicht beanspruchten Zustand jedes freie Ende der ersten ebenen Elektrode (11') sich in Bezug auf die zweite ebene Elektrode (10') entlang der zweiten Richtung (B) in einem Mindestabstand (D_{min'}) befindet, der größer als ein zweiter freier Auslenkungsabstand (D_{B'}) ist, wobei der zweite freie Auslenkungsabstand (D_{B'}) als der Mindestabstand zwischen dem ersten und dem zweiten Anschlagelement (24, 25) entlang der zweiten Richtung (B) definiert ist.

10. MEMS- oder NEMS-Vorrichtung nach einem der vorhergehenden Ansprüche, von der eine Elektrode eine ebene Platte umfasst und/oder von der eine Elektrode einen elektrostatischen Kamm umfasst.

## Claims

1. MEMS or NEMS device of sensor or actuator type, provided with a stop stack comprising:
- a first planar layer (1) comprising a first planar electrode (10) being at a first electrical potential during operation of the device and a second planar electrode (11) being, during operation of the device, at a second electrical potential differing from the first potential,
the first planar electrode (10) being movable relative to the second planar electrode (11) in a first direction (A) parallel to the first planar layer,
- a second planar layer (2) superimposed over the first planar layer (1), electrically isolated from the first planar layer (1) by at least one intermediate layer (3) formed of insulating material, the second planar layer (2) comprising a first planar element (20) mechanically attached to the first planar electrode (10), and a second planar element (21) mechanically attached to the second planar electrode (11),
- at least one stop element (24)
extending from the first planar element (20) or from the second planar element (21) in the first direction (A) and protruding from said planar element in the first direction (A),
the stop element (24) and the electrodes being configured so that the stop element (24) comes into contact with the opposing surface (23) and blocks the two planar electrodes (10, 11) from moving towards each other in the first direction (A) when under stress,
**characterized in that** the stop element (24) which extends from one of the planar elements is intended to be at the same potential as an opposing surface (23) belonging to the other of the planar elements (21).

2. The MEMS or NEMS device according to claim 1, wherein the stop element and the electrodes are configured so that, in the non-stressed state, any free end (101) of the first planar electrode (10) in relation to a closest end of the second planar electrode (102) in the first direction (A), lies at a minimum distance (Dₘᵢₙ) greater than a first free travel distance (D_{B}), said distance being defined as the minimum distance between the stop element (24) and the opposing surface.

3. The MEMS or NEMS device according to claim 2, wherein the minimum distance (Dₘᵢₙ) is greater than the sum of the first free travel distance (D_{B}) and a second predetermined distance, below which there is a risk of loss of insulating nature of the gas surrounding the electrodes (10, 11) with possible short-circuiting between two ends of the electrodes (101, 102).

4. The MEMS or NEMS device according to any one of claims 1 to 3, wherein at least one first planar electrode (11') is at least partly deformable in the first direction (A), the sum of the maximum possible deformations in the first direction (A) of the electrodes (10', 11') defining an electrode deflection distance (D_{FE}), the minimum distance (Dₘᵢₙ) being taken to be greater than the sum of the first free travel distance (D_{B}) and the electrode deflection distance (D_{FE}).

5. The MEMS or NEMS device according to any one of claims 1 to 4, wherein at least one first planar element (20) is at least partly deformable in the first direction (A), the sum of the maximum possible deformations in the first direction (A) of the planar elements (20, 21) defining a given planar element deflection distance (D_{FP}), the minimum distance (Dₘᵢₙ) being taken to be greater than the sum of the first free travel distance (D_{B}) and the planar element deflection distance (D_{FP}).

6. The MEMS or NEMS device according to claim 5, wherein at least one of the two planar elements (20, 21) is partly deformable in the first direction (A),
the second planar layer (2) being pierced with a cavity (26) made at the anchor of the stop element (24), and/or being pierced with a cavity (27) made along an outer edge of the opposing surface (23) of the stop element (24),
the planar element deflection distance (D_{FP}) being defined as the sum of the dimensions in the first direction (A) of the two cavities (26, 27), or optionally defined as the dimension in the first direction of the single cavity, made in the second planar layer (2).

7. The MEMS or NEMS device according to claim 4 and claim 5 taken in combination, wherein the two planar electrodes (10', 11') and the two planar elements (20, 21) are deformable in the first direction (A), the first planar element (21) carrying a first stop element (25) and the second planar element (20) carrying a second stop element (24),
a first through cavity (13) being made through the entire height of the stack at the anchor of the first stop element (25), corresponding in the first direction (A) with said first stop element (25), but not corresponding in the first direction (A) with the second stop element (24), forming a first flexible strip (14),
a second through cavity (12) being made through the entire height of the stack at the anchor of the second stop element (24), corresponding in the first direction (A) with said second stop element (24), but not corresponding in the first direction (A) with the first stop element (25), forming a second flexible strip (15),
the first free travel distance (D_{B}) being defined as the minimum distance between the first stop element (25) and the opposing surface, the electrode deflection distance (D_{FE}) being defined as the sum of the dimensions in the first direction (A) of the two through cavities (12, 13).

8. The MEMS or NEMS device according to claim 4 and claim 5 taken in combination, wherein the first planar element (21) carries a first stop element (25) and the second planar element (20) carries a second stop element (24),
and wherein a first through cavity (13') is made through the entire height of the stack in the first planar electrode (11'), corresponding in the first direction (A) with one end (22') of the opposing second stop element (24), forming a first flexible strip (15'),
and a second through cavity (13") is made through the entire height of the stack in the first planar electrode (11'), at the anchor of the first stop element (25) in the first direction (A), and corresponding in the first direction (A) with said first stop element (25), forming a second flexible strip (15"),
the first free travel distance (D_{B}) being defined as the minimum distance between the first stop element (25) and the opposing surface.

9. The MEMS or NEMS device according to any one of claims 1 to 8, wherein the two planar electrodes are also movable relative to each other in a second direction (B) substantially perpendicular to the first direction (A),
the second direction (B) being parallel to the planar layer (1) containing the electrodes,
and wherein the first planar element (21) carries a first stop element (25) and the second planar element (20) carries a second stop element (24),
the stack being configured so that, in the non-stressed state, any free end of the first planar electrode (11') in relation to the second planar electrode (10') in the second direction (B), lies at a minimum distance (Dₘᵢₙ') greater than a second free travel distance (D_{B}'), the second free travel distance (D_{B}') being defined as the minimum distance between the first and second stop elements (24, 25) in the second direction (B) .

10. The MEMS or NEMS device according to any one of the preceding claims, in which one electrode comprises a planar plate and/or in which one electrode comprises an electrostatic comb.
